Europäisches Patentamt

European Patent Office

Office européen des brevets

(19)

(11) Veröffentlichungsnummer: **0 187 327
B1**

(12) # EUROPÄISCHE PATENTSCHRIFT

(45) Veröffentlichungstag der Patentschrift:
**08.03.89**

(51) Int. Cl.⁴: **H05K 13/08, H05K 13/02**

(21) Anmeldenummer: **85116169.5**

(22) Anmeldetag: **18.12.85**

(54) **Sensor zur Bauteilbestückung.**

(30) Priorität: **08.01.85 DE 3500421**

(43) Veröffentlichungstag der Anmeldung:
**16.07.86 Patentblatt 86/29**

(45) Bekanntmachung des Hinweises auf die Patenterteilung:
**08.03.89 Patentblatt 89/10**

(84) Benannte Vertragsstaaten:
**AT BE CH DE FR GB IT LI LU NL SE**

(56) Entgegenhaltungen:
**DE-B- 2 031 241
US-A- 4 219 053**

(73) Patentinhaber: **Siemens Aktiengesellschaft Berlin und München, Wittelsbacherplatz 2, D-8000 München 2(DE)**

(72) Erfinder: **Schneider, Bernd, Ing. grad.,
Harthauserstrasse 79, D-8000 München 90(DE)**
Erfinder: **Müller, Stefan, Agnes-Bernauer-Strasse 11,
D-8000 München 21(DE)**

## Beschreibung

Die Erfindung bezieht sich auf einen Sensor zur Erfassung der Position von Anschlußdrähten elektronischer Bauelemente bei der automatischen Bauteilbestückung.

Beim Greifen der Bauelemente am Körper tritt das Problem der unbekannten Bauteilbeineposition bei bekannter Greiferposition auf. Dies kommt dadurch zustande, daß bei der Fertigung der elektronischen Bauteile oft große Toleranzen zwischen dem Bauteilbeinchenraster und der Bauteilaußenkontur auftreten. Die Einsetzzuverlässigkeit wird dadurch beim automatischen Bestücken so stark beeinträchtigt, daß ein automatisches Bestücken solcher Bauteile bisher nicht möglich war.

Der Erfindung liegt die Aufgabe zugrunde, einen Sensor der eingangs erläuterten Art zu konzipieren. Damit soll auch eine Prüfung möglich sein, ob eines oder beide Beinchen so stark verbogen sind, daß eine Positionserfassung durch den Sensor nicht mehr möglich ist.

Diese Aufgabe wird entsprechend dem kennzeichnenden Teil des Anspruchs 1 gelöst.

Mit dem Sensor nach der Erfindung werden die Positionen der Bauteilbeine bei in einem Greifer aufgenommenen Bauteil unmittelbar vor dem Einsetzen gemessen. Das Ergebnis kann — wenn notwendig — zur Lagekorrektur oder zur selektiven Gut-Schlecht-Erkennung des Bauteils verwendet werden. Wenn eines oder beide Bauteilbeinchen so stark verbogen sind, daß sie nicht mehr in die Fangtrichter eintauchen können, wird die Hubbewegung in die Meßstellung unterbrochen und das Bauteil aussortiert.

Weitere Merkmale der Erfindung sind Gegenstand der Unteransprüche. Die Erfindung wird anhand der Figuren erläutert. Es zeigen:

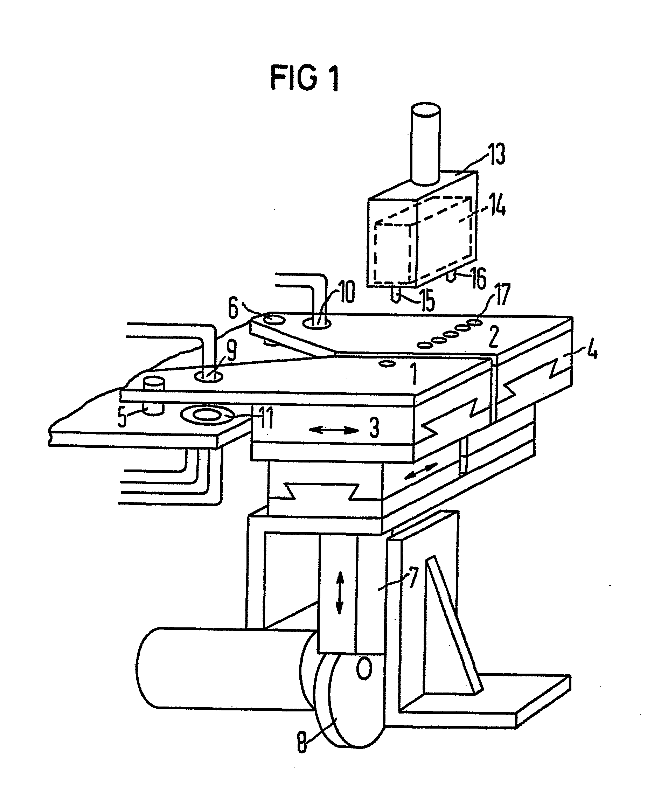

Figur 1 einen Bauteil-Beinchen-Positionssensor nach der Erfindung in einer schematischen perspektivischen Darstellung und

Figur 2 einen Schnitt des Sensors mit angedeuteter Auswerteelektronik.

In den Figuren sind zwei Bohrplatten 1, 2 auf leicht beweglichen x-, y-Schlitten 3, 4 gelagert. Die beiden Bohrplatten sind in der Ruhestellung durch Kegelspitzen 5, 6 indexiert. Die Schlitten 3, 4 sitzen auf einem weiteren Schlitten 7, der durch einen geeigneten Antrieb 8 beide Bohrplatten aus der Indexierung heraus in die Meßstellung und zurückführt. Die Bohrplatten tragen je eine Infrarot-Leuchtdiode 9, 10, denen jeweils eine fest angeordnete x, y-Positionsfotodiode 11, 12 zugeordnet ist. Über den Bohrplatten befindet sich in einem Greifer 13 ein Bauteil 14 mit seinen Anschlußbeinchen 15, 16. Darunter sind Fangtrichter 17 angeordnet, die in auf den Beinchendurchmesser abgestimmte Fangbohrungen 18 übergehen.

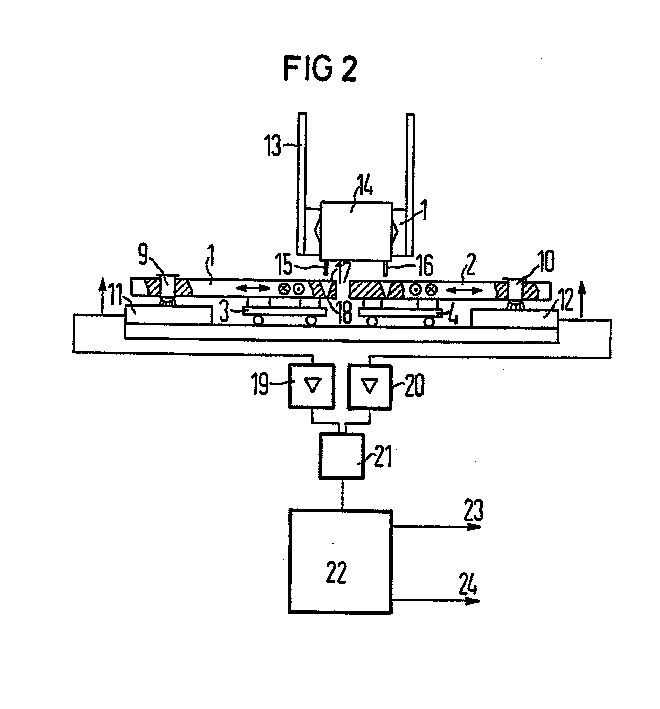

Aus der Figur 2 sind ferner zwei Verstärker 19, 20 mit einer anschließenden Auswertelektronik 21 zu erkennen. Eine Steuerung 22 ist an die Auswerteelektronik angeschlossen, die entweder über 23 das Aussortieren des Bauteils veranlaßt bzw. über 24 eine Lagekorrektur am Bestückautomaten durchführt.

Die Fangtrichter in den Bohrplatten sind so angebracht, daß in der indexierten Nullstellung der Abstand der Trichter zueinander ein Vielfaches des Rastermaßes beträgt.

Die Funktion des Sensors erfolgt folgendermaßen:

Das im Greifer 13 aufgenommene Bauteil 14 wird so über dem Sensor positioniert, daß sich die Sollpositionen der Bauteilbeine 15, 16 genau über den zugehörigen Fangbohrungen 17 befinden. Der Arbeitshub nach oben setzt die Bohrplatten 1, 2 aus der Indexierung 5, 6 frei. Dabei werden die Bohrplatten durch die in die Fangtrichter 17 eintauchenden Bauteilbeine um den Betrag der Fehlstellung der Beine aus der Nullposition in x, y-Richtung ausgelenkt.

Die Messung der Auslenkung erfolgt über die Änderung der Lichtpunktposition der Leuchtdioden 9, 10 auf der aktiven Fläche der Positionierfotodioden 11, 12. Die Signalauswertung stellt den Betrag der Fehllage jedes Bauteilbeines in x- und y-Richtung bereit.

Das Meßergebnis kann auf verschiedene Arten ausgewertet werden:

Über einen elektronischen Fensterdiskriminator kann für jedes Bein der Bereich der noch zulässigen, beim Einsetzen zum Fügeerfolg führenden Abweichung eingestellt werden. Bauelemente, deren Anschlußbeine außerhalb dieses Bereiches liegen, können über eine Programmroutine ausgesondert werden.

Eine andere Möglichkeit besteht darin, das Meßsignal (beispielsweise über eine Sensorschnittstelle) auf die Steuerung des Einsetzgerätes (beispielsweise eines Industrieroboters) zu geben und mit den Abweichungen von der Sollposition als Stellgröße beim Einsetzen eine Lagekorrektur durchzuführen.

Dadurch ist trotz falscher Absolutposition der Bauteilbeine das Einsetzen möglich. Bauteile, bei denen der Abstand der Beine untereinander außerhalb der für das Einsetzen erforderlichen Toleranz liegt, können ausgesondert werden.

Eventuell im Einsetzgerät vorhandene Systemfehler (zum Beispiel Temperaturgang) werden bei der Messung mit erfaßt und können damit kompensiert werden.

Durch die Anordnung der Fangtrichter im Rastermaß können zweiteilige Bauteile beliebiger Größe gemessen werden.

## Patentansprüche

1. Sensor zur Erfassung der Position von Anschlußdrähten elektronischer Bauelemente bei der automatischen Bauteilbestückung, dadurch gekennzeichnet, daß zwei in der Ruhestellung indexierte (5, 6) Bohrplatten (1, 2) durch einen Antrieb (8) entlang einer Linearführung (7) nach oben in eine Meßstellung verschiebbar sind, dadurch aus der Indexierung (5, 6) freikommen und durch weitere Linearführungen (3, 4) in x, y-Richtung frei beweglich sind, daß jede Bohrplatte (1, 2) eine Infrarotleuchtdiode (9, 10) trägt, der je eine feststehende Positions-Fotodiode (11, 12) gegenübersteht, an deren Ausgang eine Auswerteelektronik (21) vorgesehen ist, deren Ergebnis zur Lagekorrektur (24) bzw. der Gut-Schlecht-Unterscheidung (23) der Bauteile (14) dient.

2. Sensor nach Anspruch 1, dadurch gekennzeichnet, daß in den Bohrplatten (1, 2) Fangbohrungen (18) vorgesehen sind, die nach oben in Fangtrichter (17) übergehen.

3. Sensor nach Anspruch 2, dadurch gekennzeichnet, daß Fangbohrungen (18) für jede mögliche Anordnung der Anschlußdrähte vorgesehen und so angebracht sind, daß in der indexierten Nullstellung der Abstand der Trichter (17) zueinander ein Vielfaches des Rastermaßes beträgt.

4. Sensor nach Anspruch 1, dadurch gekennzeichnet, daß ein elektronischer Fensterdiskriminator vorgesehen ist, über den für jeden Anschlußdraht der Bereich der noch zulässigen, beim Einsetzen zum Fügeerfolg führenden Abweichung einstellbar ist.

## Claims

1. Sensor for recording the position of leads of electronic components during automatic component equipment, characterized in that two bore plates (1, 2) indexed (5, 6) in the rest position are displaceable by means of a drive (8) along a linear guide (7) upwards into a measuring position, are consequently released from the indexing (5, 6) and are freely movable in x, y direction by means of further linear guides (3, 4), in that each bore plate (1, 2) carries an infrared light-emitting diode (9, 10) in each case located opposite a stationary position photodiode (11, 12), at the output of which evaluation electronics (21) are provided, the result of which serves for positional correction (24) or the good/bad distinction (23) of the components (14).

2. Sensor according to Claim 1, characterized in that collecting bores (18) which merge upwards into collecting funnels (17) are provided in the bore plates (1, 2).

3. Sensor according to Claim 2, characterized in that collecting bores (18) for every possible arrangement of the connecting wires are provided and are placed so that in the indexed zero position the distance of the funnels (17) to one another is a multiple of the scanning dimension.

4. Sensor according to Claim 1, characterized in that an electronic window discriminator is provided which can be used to set for each connection wire the area of the still permissible deviation leading to a successful joint upon insertion.

## Revendications

1. Capteur pour détecter la positioin de fils de raccordement de composants électroniques lors du montage automatique des composants, caractérisé par le fait que deux plaques perforées (1, 2) indexées (5, 6) dans la position de repos sont déplaçables vers le haut par un dispositif d'entraînement (8), le long d'un guide linéaire (7), pour être amenées dans une position de mesure, sont de ce fait libérées de l'indexage (5, 6) et sont librement mobiles dans la direction x, y dans d'autres guides linéaires (3, 4), que chaque plaque perforée (1, 2) porte une diode luminescente à infrarouge (9, 10), en vis-à-vis de laquelle se trouve disposée respectivement une photodiode fixe de positionnement (11, 12), à la sortie de laquelle est raccordé un système électronique d'évaluation (21), dont le résultat est utilisé pour corriger (24) la position ou pour établir une distinction bon-mauvais (23) pour les composants (14).

2. Capteur suivant la revendication 1, caractérisé par le fait que dans les plaques perforées (1, 2) il est prévu des perçages récepteurs (18) qui se prolongent vers le haut par des entonnoirs de réception (17).

3. Capteur suivant la revendication 2, caractérisé par le fait que des perçages récepteurs (18) sont prévus pour chaque agencement possible des fils de raccordement et sont disposés de manière que dans la position nulle d'indexage, la distance réciproque des entonnoirs (17) soit égale à un multiple du pas du réseau.

4. Capteur suivant la revendication 1, caractérisé par le fait qu'il est prévu un discriminateur électronique à fenêtre, au moyen duquel la gamme de l'écart encore admissible conduisant lors de l'insertion à un assemblage réussi, est réglable pour chaque fil de raccordement.

EP 0 187 327 B1

# FIG 1

EP 0 187 327 B1

# FIG 2